# EUROPEAN PATENT APPLICATION

(11) **EP 4 412 426 A1**
(43) Date of publication of application: **07.08.2024**
(21) Application number: 22875943.7
(22) Date of filing: 20.09.2022
(51) Int. Cl.: H10K 30/50

(54) **PHOTOELECTRIC CONVERSION ELEMENT, METHOD FOR PRODUCING SAME, AND COMPOSITION**

(30) Priority: 28.09.2021 JP 2021158482
(71) Applicant: Panasonic Intellectual Property Management Co., Ltd., Kadoma-shi, Osaka 571-0057 (JP)
(72) Inventor: OKUMURA, Hiroko, Kadoma-shi Osaka 571-0057 (JP)
(74) Representative: Grünecker Patent- und Rechtsanwälte PartG mbB
(86) International application number: PCT/JP2022/035040
(87) International publication number: WO 2023/054073

(57) **Abstract**

A photoelectric conversion element 100 of the present disclosure includes a first electrode 2, a photoelectric conversion layer 4, and a second electrode 6. The photoelectric conversion layer 4 includes a photoelectric conversion material and a phosphate ester. A method for manufacturing the photoelectric conversion element of the present disclosure includes: applying a precursor solution to a base to form a coating film, the precursor solution containing a raw material of the photoelectric conversion material, the phosphate ester, and a solvent containing dimethyl sulfoxide; and baking the coating film to form a photoelectric conversion layer.

## Description

### TECHNICAL FIELD

The present invention relates to a photoelectric conversion element, a method for manufacturing the photoelectric conversion element, and a composition.

### BACKGROUND ART

Non Patent Literature 1 reports that a CsGel₃ film was formed by physical vapor deposition and that the CsGel₃ film achieved a solar cell efficiency of 0.58%.

Non Patent Literature 2 reports that a CsGel₃ film was formed by spin coating which is a coating technique and that the CsGel₃ film achieved a solar cell efficiency of 0.11%.

### CITATION LIST

### Non Patent Literature

Non Patent Literature 1: Kyle A. Montiel, and seven others, Conference Record of the IEEE Photovoltaic Specialists Conference, May 2019, pp. 1183-1186
Non Patent Literature 2: Thirumal Krishnamoorthy, and 10 others, Journal of Materials Chemistry A, October 2015, pp. 23829-23832

### SUMMARY OF INVENTION

### Technical Problem

The present disclosure aims to provide a photoelectric conversion element having a configuration suitable for improving the photoelectric conversion efficiency.

### Solution to Problem

A photoelectric conversion element of the present disclosure includes:
a first electrode;
a photoelectric conversion layer; and
a second electrode, wherein
the photoelectric conversion layer includes a photoelectric conversion material and a phosphate ester.

### Advantageous Effects of Invention

The present disclosure provides a photoelectric conversion element having a configuration suitable for improving the photoelectric conversion efficiency.

### BRIEF DESCRIPTION OF DRAWINGS

FIG. 1 shows a structural formula of triphenyl phosphate being an example of a phosphate ester.
FIG. 2 shows a weak bond likely to be formed between triphenyl phosphate and Ge.
FIG. 3 is a cross-sectional view schematically showing the configuration of a photoelectric conversion element 100 according to a first embodiment.
FIG. 4 is a graph showing I-V characteristics under one-sun irradiation of photoelectric conversion elements of Examples and Comparative Example.
FIG. 5 is a graph showing I-V characteristics under measurement of dark currents through the photoelectric conversion elements of Examples and Comparative Example.
FIG. 6 shows I-V characteristics under one-sun irradiation of an inverted CsGel₃ device.

### DESCRIPTION OF EMBODIMENTS

### <Findings on which the present disclosure is based>

Regarding photoelectric conversion elements, various manufacturing techniques have been employed to form photoelectric conversion layers including photoelectric conversion materials in an attempt to improve photoelectric conversion efficiencies of photoelectric conversion elements. For example, CsGel₃ which is one of the photoelectric conversion materials is of direct transition type with a high absorbance and is supposed to have high mobility. Therefore, for example, also for CsGel₃, various manufacturing techniques have been employed to form films in an attempt to improve the photoelectric conversion efficiencies.

As described in BACKGROUND ART, Non Patent Literature 1 reports that a CsGel₃ film was formed by physical vapor deposition and achieved a solar cell efficiency of 0.58%.

Non Patent Literature 2 reports that a CsGel₃ film was formed by spin coating which is a coating technique and achieved a solar cell efficiency of 0.11 %.

In the case that a CsGel₃ film is formed by a coating technique, in order to impart a high film quality thereto, dimethyl sulfoxide (DMSO) is used as a solvent in which Csl being a precursor is to be dissolved to prepare a precursor solution for formation of the CsGel₃ film. However, a reaction between Ge and the DMSO in the precursor solution changes the precursor solution from a yellow solution to a reddish brown gel before application. This change can make it difficult to achieve a high-film quality by a coating technique. Accordingly, a photoelectric conversion layer formed thereby has a low film quality, which decreases the power generation efficiency.

The present inventor, who has been making intensive studies on formation of photoelectric conversion layers by coating techniques, focused on phosphate esters.

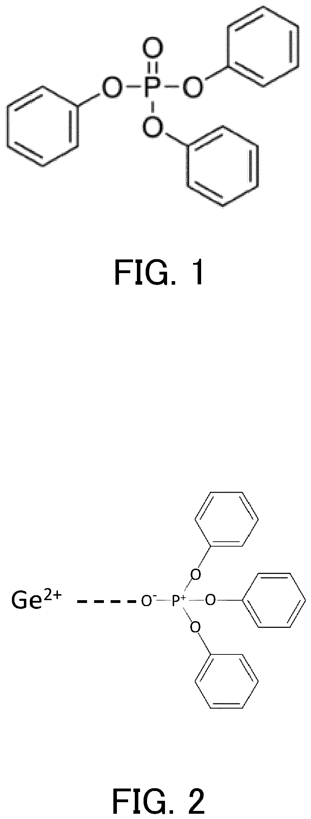

FIG. 1 shows a structural formula of triphenyl phosphate which is one of phosphate esters. FIG. 2 shows a weak bond likely to be formed between triphenyl phosphate and Ge. It is thought that a phosphate ester such as triphenyl phosphate can reduce an undesired side reaction by making a weak bond to Ge, as shown in FIG. 2. Here, the undesired side reaction refers to a reaction between Ge and DMSO. Hence, by reducing such a reaction between Ge and DMSO using a phosphate ester, the pot life of a precursor solution is extended and a high-quality film can be formed. A photoelectric conversion element including a photoelectric conversion layer composed of such a high-quality film can improve the photoelectric conversion efficiency. Moreover, after the formation of the film, the phosphate ester remaining in the film can also suppress an undesired reaction such as oxidation. Furthermore, since phosphate esters have a high boiling point, the thermal resistance and the flexibility of the photoelectric conversion layer can be improved.

Incidentally, it is thought that if a phosphite ester such as triphenyl phosphite is used instead of a phosphate ester, the phosphite ester reacts with Ge and thus fails to achieve the above-described effect.

### <Embodiments of the present disclosure>

Embodiments of the present disclosure will be hereinafter described with reference to the drawings.

### [First embodiment]

A photoelectric conversion element according to a first embodiment includes a first electrode, a photoelectric conversion layer, and a second electrode. The photoelectric conversion layer includes a photoelectric conversion material and a phosphate ester.

In the case of the photoelectric conversion element having the above configuration, a photoelectric conversion layer can have a high film quality even when formed by a coating technique. The above photoelectric conversion layer having a high film quality can improve the photoelectric conversion efficiency. That is, the photoelectric conversion element according to the first embodiment has a configuration suitable for improving the photoelectric conversion efficiency.

The photoelectric conversion layer of the photoelectric conversion element according to the first embodiment can have a high film quality when formed, for example, using the following precursor solution by a coating technique.

The precursor solution contains a raw material of the photoelectric conversion material, the phosphate ester, and a solvent containing DMSO. In order to form the photoelectric conversion layer having a high film quality, the DMSO is used as a solvent in the case where the photoelectric conversion layer is formed by a coating technique. The phosphate ester contained in the precursor solution can form a weak bond to the raw material of the photoelectric conversion material (i.e., a precursor of the photoelectric conversion material). By forming such a weak bond to the precursor, the phosphate ester can suppress a reaction between the DMSO and the precursor of the photoelectric conversion material in the precursor solution without inhibiting generation of the photoelectric conversion material. This action of the phosphate ester extends the pot life of the precursor solution and makes it possible to form a high-quality film, namely, a photoelectric conversion layer composed of a high-quality film and having improved photoelectric conversion efficiency. Moreover, after the formation of the film, the phosphate ester remaining in the film can also suppress an undesired reaction such as oxidation. Furthermore, since phosphate esters have a high boiling point, the thermal resistance and the flexibility of the photoelectric conversion layer can be improved.

The photoelectric conversion material included in the photoelectric conversion layer of the photoelectric conversion element according to the first embodiment may be a perovskite compound. The perovskite compound has a high light absorption coefficient in a wavelength range of a solar spectrum and has high carrier mobility. Hence, the perovskite compound has a high photoelectric conversion efficiency.

The perovskite compound may include at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, TI, Pb, Bi, Th, U, and Np. The perovskite compound including any of these elements and a precursor thereof can react with the DMSO to form a complex. Hence, by allowing the perovskite compound including any of these elements and the precursor thereof to be present with the phosphate ester, a reaction, such as formation of a complex, between the element and the DMSO can be suppressed. Consequently, the pot life of the above precursor solution is extended, and a high-quality film can be formed.

The perovskite compound may include Ge. In this case, the photoelectric conversion material can achieve a high photoelectric conversion efficiency.

The perovskite compound refers to a perovskite crystal structure represented by a chemical formula ABX₃ or a structure including a crystal similar thereto. Here, the A is a monovalent cation, the B is a divalent cation, and the X is a halogen anion.

The photoelectric conversion material may be a material represented by the following chemical formula (1).

ABX₃ (1)

Here, the A is a monovalent cation. The B is at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, TI, Pb, Bi, Th, U, and Np. The X is a halogen element and includes I.

The material represented by the above chemical formula (1) has a high photoelectric conversion efficiency.

The photoelectric conversion material may be a material represented by the following chemical formula (2):

AGeX₃ (2)

Here, the A is a monovalent cation. The X is a halogen element and includes I.

The material represented by the above chemical formula (2) has a high photoelectric conversion efficiency.

The monovalent cation represented by the A in the above chemical formulae (1) and (2) is, for example, an organic cation or an alkali metal cation. Examples of the organic cation include a methylammonium cation (namely, CH₃NH₃⁺), a formamidinium cation (namely, NH₂CHNH₂⁺), a phenylethylammonium cation (namely, C₆HsC₂H₄NH₃⁺), and a guanidinium cation (namely, CH₆N₃⁺). Examples of the alkali metal cation include a potassium cation (K⁺), a cesium cation (namely, Cs⁺), and a rubidium cation (Rb⁺).

The A may include a plurality of cations. The A may include both the organic cation and the alkali metal cation.

In the above chemical formula (1), the A may include Cs. The A may be Cs.

In the above chemical formula (2), the A may include Cs. The A may be Cs. That is, the photoelectric conversion material may be a material represented by CsGeX₃.

In the above chemical formula (1), the X may be I.

In the above chemical formula (2), the X may be I. That is, the photoelectric conversion material may be a material represented by AGel₃.

The photoelectric conversion material may be a material represented by CsGel₃.

Phosphite esters, for example, are excluded from the category of the phosphate ester.

The phosphate ester included in the photoelectric conversion layer is, for example, not a portion of the perovskite structure. For example, when the photoelectric conversion layer includes the perovskite compound, the phosphate ester may be included in none of the sites in the perovskite compound. For example, when the photoelectric conversion material included in the photoelectric conversion layer is the perovskite compound, the phosphate ester may be included in none of the sites in the perovskite compound as the photoelectric conversion material. For example, when the photoelectric conversion material included in the photoelectric conversion layer is the perovskite compound, the phosphate ester included in the photoelectric conversion layer may be present between crystals of the perovskite compound.

The phosphate ester may have a boiling point of 200°C or higher. In this case, the thermal resistance of the photoelectric conversion layer can be improved further. The phosphate ester has a boiling point of, for example, 400°C or lower.

The phosphate ester may include triphenyl phosphate having a structure shown in FIG. 1. In this case, the suppressing effect on the reaction of the DMSO with the photoelectric conversion material and the precursor thereof can be improved further.

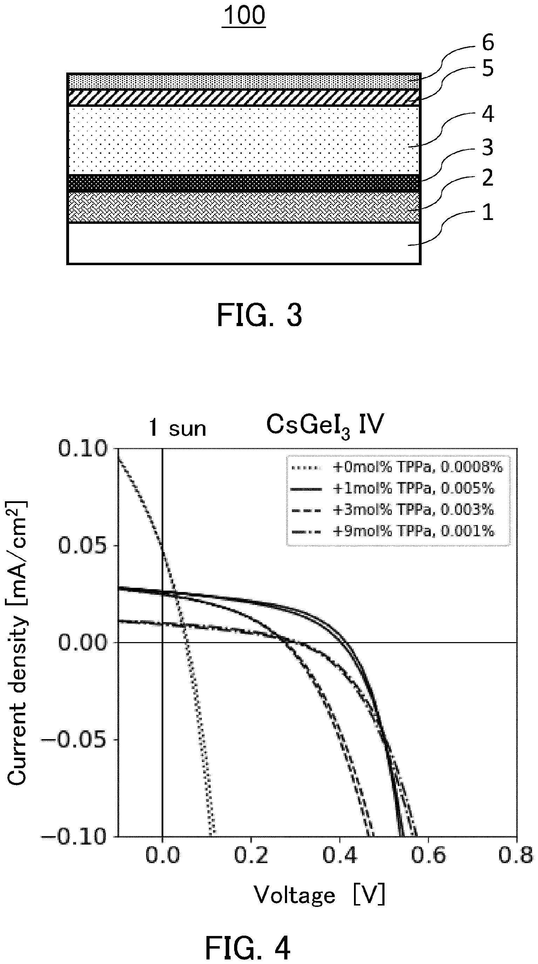

FIG. 3 is a cross-sectional view schematically showing the configuration of a photoelectric conversion element 100 according to the first embodiment.

The photoelectric conversion element 100 according to the first embodiment includes, for example, a substrate 1, a first electrode 2, an electron transport layer 3, a photoelectric conversion layer 4, a hole transport layer 5, and a second electrode 6 in this order. The substrate 1, the electron transport layer 3, and the hole transport layer 5 may be omitted.

Upon irradiation of the photoelectric conversion element 100 with light, the photoelectric conversion layer 4 absorbs the light and then charge separation into electrons and holes occurs. The electrons resulting from this charge separation transfer to the first electrode 2 through the electron transport layer 3. On the other hand, the holes formed in the photoelectric conversion layer 4 transfer to the second electrode 6 via the hole transport layer 5. The photoelectric conversion element 100 can thereby draw out an electric current from the first electrode 2 as a negative electrode and the second electrode 6 as a positive electrode.

The components of the photoelectric conversion element 100 will be specifically described hereinafter.

### (Substrate 1)

The substrate 1 is an accessory component. The substrate 1 supports the layers in the photoelectric conversion element 100. The substrate 1 can be formed using a transparent material. A glass substrate or a plastic substrate, for example, can be used as the substrate 1. The plastic substrate may be, for example, a plastic film.

When the second electrode 6 has a light-transmitting property, the substrate 1 may be made of a material not having a light-transmissive property. As the material can be used a metal, a ceramic, or a resin material having a low light-transmitting property.

When the first electrode 2 is strong enough to support the layers, the substrate 1 may be omitted.

### (First electrode 2)

The first electrode 2 has electrical conductivity.

The first electrode 2 has a light-transmitting property. For example, the first electrode 2 allows visible to near-infrared light to pass therethrough.

The first electrode 2 is made of, for example, a material being transparent and having electrical conductivity. The material is, for example, a metal oxide or a metal nitride. The material is, for example,
(i) titanium oxide doped with at least one selected from the group consisting of lithium, magnesium, niobium, and fluorine,
(ii) gallium oxide doped with at least one selected from the group consisting of tin and silicon,
(iii) gallium nitride doped with at least one selected from the group consisting of silicon and oxygen,
(iv) tin oxide doped with at least one selected from the group consisting of antimony and fluorine,
(v) zinc oxide doped with at least one selected from the group consisting of boron, aluminum, gallium, and indium,
(vi) indium-tin composite oxide, or
(vii) a composite thereof.

The first electrode 2 may be formed to have a pattern that allows light to pass therethrough. The pattern that allows light to pass therethrough is, for example, a linear pattern, a wave line pattern, a lattice pattern, or a perforated-metal-like pattern where a lot of small through holes are regularly or irregularly arranged. When the first electrode 2 has any of these patterns, light can pass through portions without the electrode material. Thus, the first electrode 2 having the pattern that allows light to pass therethrough can include a non-transparent material. Examples of the non-transparent electrode material include platinum, gold, silver, copper, aluminum, rhodium, indium, titanium, iron, nickel, tin, zinc, or an alloy including any of these. An electrically conductive carbon material may be used as the non-transparent electrode material.

The light-transmitting property of the first electrode 2 is not necessarily achieved by the above-described pattern that allows light to pass therethrough. For example, the first electrode 2 may be formed as a thin metal film having a thickness of approximately 10 nm. The thin metal film is made of, for example, platinum, gold, silver, copper, aluminum, rhodium, indium, titanium, iron, nickel, tin, zinc, or an alloy including any of these. An electrically conductive carbon material may be used in place of these metal materials.

In the case where the photoelectric conversion element 100 does not include the electron transport layer 3, the first electrode 2 has a property of blocking holes from the photoelectric conversion layer 4. In this case, the first electrode 2 is not in ohmic contact with the photoelectric conversion layer 4. The property of blocking holes from the photoelectric conversion layer 4 is a property of allowing only electrons formed in the photoelectric conversion layer 4 to pass and not allowing holes to pass. The Fermi energy of a material having such a property is higher than the energy of the photoelectric conversion layer 4 at an upper part of the valence band. The Fermi energy of a material having such a property may be higher than the Fermi energy of the photoelectric conversion layer 4. The material is specifically aluminum.

In the case where the photoelectric conversion element 100 includes the electron transport layer 3, the first electrode 2 does not necessarily have the property of blocking holes from the photoelectric conversion layer 4. In this case, the first electrode 2 can include a material capable of forming an ohmic contact with the photoelectric conversion layer 4. In this case, the first electrode 2 may be in ohmic contact with the photoelectric conversion layer 4, or is not necessarily in ohmic contact with the photoelectric conversion layer 4.

The transmittance of the first electrode 2 may be, for example, 50% or more, or 80% or more. The wavelength of light that is to pass through the first electrode 2 depends on the absorption wavelength of the photoelectric conversion layer 4.

The thickness of the first electrode 2 may be, for example, 1 nm or more and 1000 nm or less.

### (Electron transport layer 3)

The electron transport layer 3 includes a semiconductor. The electron transport layer 3 may be made of a semiconductor having a band gap of 3.0 eV or more. In this case, visible light and infrared light are allowed to pass therethrough to the photoelectric conversion layer 4. The semiconductor is, for example, an inorganic n-type semiconductor.

Examples of the inorganic n-type semiconductor include a metal oxide, a metal nitride, and a perovskite oxide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂ or SnO₂. The metal nitride is, for example, GaN. The perovskite oxide is, for example, SrTiOs or CaTiOs.

The electron transport layer 3 may include a semiconductor having a band gap of 6.0 eV or more to effectively allow, in particular, ultraviolet to pass therethrough to the photoelectric conversion layer 4. Examples of the semiconductor include halides, such as lithium fluoride and calcium fluoride, of alkali metals and alkaline earth metals, alkali metal oxides such as magnesium oxide, and silicon dioxide. In this case, the electron transport layer 3 may have a thickness of, for example, 10 nm or less to secure the electron transport capability of the electron transport layer 3.

The electron transport layer 3 may include a plurality of layers made of different materials.

### (Photoelectric conversion layer 4)

The photoelectric conversion layer 4 includes a photoelectric conversion material and a phosphate ester.

The materials described above can be used as the photoelectric conversion material and the phosphate ester.

To improve the photoelectric conversion efficiency of the photoelectric conversion element 100, an amount of the phosphate ester in the photoelectric conversion layer 4 may be more than 0 mol% and 9 mol% or less, or 1 mol% or more and 9 mol% or less. To further improve the photoelectric conversion efficiency, the amount may be 1 mol% or more and 3 mol% or less.

The thickness of the photoelectric conversion layer 4 is, for example, 50 nm or more and 10 µm or less.

The photoelectric conversion layer 4 can be formed, for example, by a coating technique involving a solution. Examples of the coating technique include doctor blade coating, bar coating, spraying, dip coating, inkjet coating, slit coating (namely, die coating), and spin coating.

The photoelectric conversion layer 4 may include a perovskite compound as the photoelectric conversion material as its main component. Saying that "the photoelectric conversion layer 4 includes a perovskite compound as its main component" means that the perovskite compound accounts for 50 mass% or more of the photoelectric conversion layer 4. The perovskite compound may account for 70 mass% or more of the photoelectric conversion layer 4. The perovskite compound may account for 90 mass% or more of the photoelectric conversion layer 4.

### (Hole transport layer 5)

The hole transport layer 5 includes a hole transport material. The hole transport material is a material that transports a hole. The hole transport material is, for example, an organic semiconductor or an inorganic semiconductor.

Examples of the organic semiconductor include triphenylamine, triallylamine, phenylbenzidine, phenylenevinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Typical examples of the organic semiconductor used as the hole transport material include 2,2',7,7'-tetrakis-(N,N-di-p-methoxyphenylamine)9,9'-spirobifluorene, poly[bis(4-phenyl)(2,4,6-trimethylphenyl)amine] (which may be referred to as "PTAA" hereinafter), poly(3-hexylthiophene-2,5-diyl), poly(3,4-ethylenedioxythiophene), and copper phthalocyanine.

The inorganic semiconductor used as the hole transport material is a p-type semiconductor. Examples of the inorganic semiconductor include Cu₂O, CuGaO₂, CuSCN, Cui, NiOₓ, MoOₓ, V₂O₅, and a carbon material such as graphene oxide. Here, x satisfies x > 0.

The hole transport layer 5 may include a plurality of layers made of different materials. For example, hole transport properties of the hole transport layer 5 are improved by stacking the plurality of layers whose ionization potentials are smaller than that of the photoelectric conversion layer 4 such that the ionization potentials decrease layer by layer.

The thickness of the hole transport layer 5 may be 1 nm or more and 1000 nm or less, or 10 nm or more and 50 nm or less. This allows the hole transport layer 5 to exhibit sufficiently high hole transport properties. Consequently, the resistance of the photoelectric conversion element 100 can be maintained at a low level, and a high photoelectric conversion efficiency can be achieved.

The hole transport layer 5 is formed, for example, by a coating technique, a printing technique, or a deposition technique. The same can be said to the photoelectric conversion layer 4. Examples of the coating technique include doctor blade coating, bar coating, spraying, dip coating, inkjet coating, slit coating (namely, die coating), and spin coating. Examples of the printing technique include screen printing. If needed, the hole transport layer 5 may be formed using a mixture of a plurality of materials and then, for example, compressed or baked. In the case that the material of the hole transport layer 5 is a low-molecular-weight organic substance or an inorganic semiconductor, the hole transport layer 5 can be produced by vacuum deposition.

The hole transport layer 5 may include not only the hole transport material but an additive to increase the electrical conductivity. Examples of the additive include a supporting electrolyte, a solvent, and a dopant. The supporting electrolyte and the solvent stabilize holes in the hole transport layer 5. The dopant increases the number of holes in the hole transport layer 5.

Examples of the supporting electrolyte include an ammonium salt, an alkaline earth metal salt, and a transition metal salt. Examples of the ammonium salt include tetrabutylammonium perchlorate, tetraethylammonium hexafluorophosphate, an imidazolium salt, and a pyridinium salt. Examples of the alkali metal salt include lithium perchlorate and potassium tetrafluoroborate. Examples of the alkaline earth metal salt include lithium bis(trifluoromethanesulfonyl)imide and calcium(II) bis(trifluoromethanesulfonyl)imide. Examples of the transition metal salt include zinc(II) bis(trifluoromethanesulfonyl)imide and tris[4-tert-butyl-2-(1H-pyrazole-1-yl)pyridine]cobalt(III) tris(trifluoromethanesulfonyl)imide.

Examples of the dopant include a fluorine-containing aromatic boron compound. Examples of the fluorine-containing aromatic boron compound include tris(pentafluorophenyl)borane.

The solvent included in the hole transport layer 5 may have excellent ion conductivity. The solvent may be an aqueous solvent or an organic solvent. To make the solute more stable, the solvent included in the hole transport layer 5 may be an organic solvent. Examples of the organic solvent include heterocyclic compound solvents such as tert-butylpyridine, pyridine, and n-methylpyrrolidone.

An ionic liquid may be used as the solvent. The ionic liquid may be used alone, or may be used after mixed with a different solvent. The ionic liquid is desirable for its low volatility and high flame retardancy.

Examples of the ionic liquid include imidazolium ionic liquids such as 1-ethyl-3-methylimidazolium tetracyano borate, pyridine ionic liquids, alicyclic amine ionic liquids, aliphatic amine ionic liquids, and azonium amine ionic liquids.

### (Second electrode 6)

The second electrode 6 has electrical conductivity.

In the case where the photoelectric conversion element 100 does not include the hole transport layer 5, the second electrode 6 has a property of blocking electrons from the photoelectric conversion layer 4. In this case, the second electrode 6 is not in ohmic contact with the photoelectric conversion layer 4. The property of blocking electrons from the photoelectric conversion layer 4 refers to a property of allowing only holes formed in the photoelectric conversion layer 4 to pass and not allowing electrons to pass. The Fermi energy of a material having such a property is lower than the energy of the photoelectric conversion layer 4 at a lower part of the conduction band. The Fermi energy of a material having such a property may be lower than the Fermi energy of the photoelectric conversion layer 4. The material is specifically platinum, gold, or a carbon material such as graphene.

In the case where the photoelectric conversion element 100 includes the hole transport layer 5, the second electrode 6 does not necessarily have the property of blocking electrons from the photoelectric conversion layer 4. In this case, the second electrode 6 can include a material capable of forming an ohmic contact with the photoelectric conversion layer 4. Therefore, the second electrode 6 can be formed to have a light-transmitting property.

An electrode that is the first electrode 2 or the second electrode 6 and that is configured to allow light to be incident thereon needs to have a light-transmitting property. That is, either the first electrode 2 or the second electrode 6 does not necessarily have a light-transmitting property. That is, either the first electrode 2 or the second electrode 6 does not necessarily include a material having a light-transmitting property, or does not necessarily have a pattern including an opening portion that allows light to pass therethrough.

### (Porous layer)

A porous layer is formed on the electron transport layer 3, for example, by a coating technique. In the case that the photoelectric conversion element 100 does not include the electron transport layer 3, the porous layer is formed on the first electrode 2.

A pore structure provided by the porous layer serves as a foundation at the time of formation of the photoelectric conversion layer 4. The porous layer does not prevent light absorption by the photoelectric conversion layer 4 and electron transfer from the photoelectric conversion layer 4 to the electron transport layer 3.

The porous layer includes a porous body.

The porous body is made of, for example, continuous insulating particles or continuous semiconductor particles. The insulating particles are, for example, aluminum oxide particles or silicon oxide particles. The semiconductor particles are, for example, inorganic semiconductor particles. The inorganic semiconductor is, for example, a metal oxide, a perovskite oxide of a metal element, a sulfide of a metal element, or a metal chalcogenide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂. The perovskite oxide of a metal element is, for example, SrTiOs or CaTiOs. The sulfide of a metal element is, for example, CdS, ZnS, In₂S₃, PbS, Mo₂S, WS₂, Sb₂S₃, Bi₂S₃, ZnCdS₂, or Cu₂S. The metal chalcogenide is, for example, CsSe, In₂Se₃, WSe₂, HgS, PbSe, or CdTe.

The thickness of the porous layer may be 0.01 µm or more and 10 µm or less, or 0.05 µm or more and 1 µm or less.

Regarding surface roughness of the porous layer, a surface roughness factor determined by "effective area/projected area" may be 10 or greater, or 100 or greater. The projected area refers to the area of a shadow behind an object irradiated with light from the front. The effective area refers to the actual surface area of an object. The effective area can be calculated from a volume of an object, the specific surface area of the material of the object, and the bulk density of the material of the object, the volume being determined from the projected area and the thickness of the object. The specific surface area is measured, for example, by a nitrogen adsorption method.

A void in the porous layer is continuous from one principal surface of the porous layer to the other principal surface. That is, a void in the porous layer is continuous from a principal surface of the porous layer in contact with the photoelectric conversion layer 4 to a principal surface of the porous layer in contact with the electron transport layer 3. This allows the material of the photoelectric conversion layer 4 to fill the void of the porous layer and reach the surface of the electron transport layer 3. The photoelectric conversion layer 4 and the electron transport layer 3 are thus in direct contact to each other and therefore can give and receive electrons therebetween.

Inclusion of the porous layer makes it easy to form the photoelectric conversion layer 4. When the porous layer is included, the material of the photoelectric conversion layer 4 enters the void of the porous layer and the porous layer serves as a foothold for the photoelectric conversion layer 4. This makes it unlikely that the material of the photoelectric conversion layer 4 is repelled by the surface of the porous layer or aggregates on the surface of the porous layer. Consequently, the photoelectric conversion layer 4 can be easily formed as a uniform film. The photoelectric conversion layer 4 can be formed by the above coating technique or the like.

The porous layer can increase the optical path length of light passing through the photoelectric conversion layer 4 by causing light scattering. The amount of electrons and holes formed in the photoelectric conversion layer 4 is expected to increase with the increase of the optical path length.

As described above, the photoelectric conversion layer of the photoelectric conversion element according to the first embodiment is formed, for example, by the coating technique. Therefore, the method for manufacturing the photoelectric conversion element according to the first embodiment may be a manufacturing method including, for example: applying a precursor solution to a base to form a coating film, the precursor solution containing a raw material of the photoelectric conversion material, a phosphate ester, a solvent containing DMSO; and baking the coating film to form a photoelectric conversion layer. Incidentally, the term "base" means a member serving as an underlayer when the photoelectric conversion layer is formed by application. That is, in the case of the photoelectric conversion element 100 having the configuration shown in FIG. 3, for example, the electron transport layer 3 on which the photoelectric conversion layer 4 is placed corresponds to the base. In the case that the photoelectric conversion layer is formed on the porous layer, the porous layer corresponds to the base.

The material of the phosphate ester included in the above-described photoelectric conversion layer can be used as the phosphate ester contained in the precursor solution. That is, a phosphate ester having a boiling point of 200°C or higher may be used. Moreover, the phosphate ester may be triphenyl phosphate. In this case, the suppressing effect on a reaction of the photoelectric conversion material and the precursor thereof with the DMSO can be improved.

The raw material of the photoelectric conversion material in the precursor solution is required to be a substance that can be a raw material of the intended photoelectric conversion material, but is not limited to a particular one. For example, when the intended photoelectric conversion material is represented by the above chemical formula (1), a precursor solution may contain, as the raw material of the photoelectric conversion material: a first compound including A and a first halogen element as constituent elements; and a second compound including B and a second halogen element as constituent elements. In this case, at least one selected from the group consisting of the first halogen element and the second halogen element includes I.

The A included in the first compound may be an alkali metal element. For example, the first compound may be cesium iodide (namely, Csl).

The solvent of the precursor solution may further contain dimethylformamide (DMF). That is, the precursor solution may contain, as its solvent, DMF as well as the DMSO.

As described above, for the photoelectric conversion element according to the first embodiment, the amount of the phosphate ester in the photoelectric conversion layer may be, for example, more than 0 mol% and 9 mol% or less to improve the photoelectric conversion efficiency. Therefore, the precursor solution may contain the phosphate ester so that the amount of the phosphate ester in the photoelectric conversion layer formed is more than 0 mol% and 9 mol% or less.

### [Second embodiment]

A composition according to a second embodiment will be described hereinafter. The features specified in the first embodiment may be omitted as appropriate.

The composition according to the second embodiment includes: at least one selected from the group consisting of a photoelectric conversion material and a precursor of the photoelectric conversion material; a solvent containing DMSO; and a phosphate ester. The materials described as the photoelectric conversion material and the phosphate ester in the first embodiment can be used as the photoelectric conversion material and the phosphate ester in the composition according to the second embodiment.

For example, when including the precursor of the photoelectric conversion material, the composition according to the second embodiment can be used as the precursor solution used in the method for manufacturing the photoelectric conversion element described in the first embodiment.

When including the photoelectric conversion material, the composition according to the second embodiment can be, for example, a composition in which the synthesized photoelectric conversion material, the solvent containing the DMSO, and the phosphate ester are simultaneously present, the composition being generated in a process of forming the photoelectric conversion layer. Furthermore, if the DMSO remains in the photoelectric conversion layer formed, the photoelectric conversion layer corresponds to a layer composed of the composition according to the second embodiment.

As described above, the photoelectric conversion material in the composition according to the second embodiment corresponds to the photoelectric conversion material described in the first embodiment. For example, in the composition according to the second embodiment, the photoelectric conversion material may be a perovskite compound. The perovskite compound may include at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, Tl, Pb, Bi, Th, U, and Np. The photoelectric conversion material including any of these elements can react with the DMSO to form bonds such as complexes. Hence, the reaction can be suppressed by allowing the photoelectric conversion material to be present with the phosphate ester. Consequently, the pot life of the composition is extended, and a high-quality film can be formed using the composition according to the second embodiment.

The perovskite compound may include Ge. In this case, the photoelectric conversion material can achieve a high photoelectric conversion efficiency.

The photoelectric conversion material may be the material represented by the following chemical formula (2) described also in the first embodiment:

AGeX₃ (2)

, where
the A is a monovalent cation, and
the X is a halogen element and includes I.

The material represented by the chemical formula (2) has a high photoelectric conversion efficiency.

The above monovalent cation is, for example, an organic cation or an alkali metal cation. Examples of the organic cation include a methylammonium cation (namely, CH₃NH₃⁺), a formamidinium cation (namely, NH₂CHNH₂⁺), a phenylethylammonium cation (namely, C₆H₅C₂H₄NH₃⁺), and a guanidinium cation (namely, CH₆N₃⁺). Examples of the alkali metal cation include a potassium cation (K⁺), a cesium cation (namely, Cs⁺), and a rubidium cation (Rb⁺).

The A may include a plurality of cations. The A may include both the organic cation and the alkali metal cation.

In the chemical formula (2), the A may include Cs. The A may be Cs.

In the chemical formula (2), the X may be I. That is, the photoelectric conversion material may be a material represented by AGel₃.

In the composition according to the second embodiment, the solvent may further contain DMF. That is, the composition according to the second embodiment may include, as its solvent, DMF as well as the DMSO.

The phosphate ester included in the composition according to the second embodiment may have a boiling point of 200°C or higher.

The phosphate ester may include triphenyl phosphate. In this case, the suppressing effect on a reaction between the photoelectric conversion material and the DMSO can be improved.

The composition according to the second embodiment may further include a compound composed of an alkali metal element and a halogen element. The compound is, for example, cesium iodide (Csl).

### [Other embodiments]

### (Supplement)

According to the description of the above embodiments, the following techniques are disclosed.

### (Technique 1)

A photoelectric conversion element including:
a first electrode;
a photoelectric conversion layer; and
a second electrode, wherein
the photoelectric conversion layer includes a photoelectric conversion material and a phosphate ester.

This configuration allows the photoelectric conversion layer to have a high film quality even when the photoelectric conversion layer is formed by a coating technique. The photoelectric conversion layer having a high film quality can improve the photoelectric conversion efficiency. That is, the photoelectric conversion element of the technique 1 has a configuration suitable for improving the photoelectric conversion efficiency.

### (Technique 2)

The photoelectric conversion element according to the technique 1, wherein
the photoelectric conversion material is a perovskite compound, and
the perovskite compound includes at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, Tl, Pb, Bi, Th, U, and Np.

The photoelectric conversion element of the technique 2 configured as above can improve the photoelectric conversion efficiency.

### (Technique3)

The photoelectric conversion element of the technique 2, wherein the perovskite compound includes Ge.

The photoelectric conversion element of the technique 3 configured as above can further improve the photoelectric conversion efficiency.

### (Technique 4)

The photoelectric conversion element of the technique 2 or 3, wherein the phosphate ester is present between crystals of the perovskite compound.

The photoelectric conversion element of the technique 4 configured as above allows the phosphate ester to be effectively fulfill its function and can improve the photoelectric conversion efficiency.

### (Technique 5)

The photoelectric conversion element according to any one of the techniques 1 to 4, wherein
the photoelectric conversion material is represented by the following chemical formula (1):

ABX₃ (1)

, where
A is a monovalent cation,
B is at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, Tl, Pb, Bi, Th, U, and Np, and
X is a halogen element and includes I.

The photoelectric conversion element of the technique 5 configured as above can improve the photoelectric conversion efficiency.

### (Technique 6)

The photoelectric conversion element of the technique 5, wherein the A includes Cs.

The photoelectric conversion material of the photoelectric conversion element of the technique 6 configured as above can have a high absorbance and a high mobility. Therefore, the photoelectric conversion element of the technique 6 can further improve the photoelectric conversion efficiency.

### (Technique 7)

The photoelectric conversion element according to any one of the techniques 1 to 6, wherein the phosphate ester has a boiling point of 200°C or higher.

The photoelectric conversion element of the technique 7 configured as above can improve the thermal resistance.

### (Technique 8)

The photoelectric conversion element according to any one of the techniques 1 to 7, wherein the phosphate ester includes triphenyl phosphate.

The photoelectric conversion element of the technique 8 configured as above can improve the photoelectric conversion efficiency.

### (Technique 9)

The photoelectric conversion element of any one of the techniques 1 to 8, wherein an amount of the phosphate ester in the photoelectric conversion layer is more than 0 mol% and 9 mol% or less.

The photoelectric conversion element of the technique 9 configured as above can improve the photoelectric conversion efficiency.

### (Technique 10)

A method for manufacturing the photoelectric conversion element according to any one of the techniques 1 to 9, the method including:
applying a precursor solution to a base to form a coating film, the precursor solution containing a raw material of the photoelectric conversion material, the phosphate ester, and a solvent containing dimethyl sulfoxide; and
baking the coating film to form the photoelectric conversion layer.

The precursor solution configured as above and containing the phosphate ester can suppress a reaction between the dimethyl sulfoxide and the precursor of the photoelectric conversion material in the precursor solution without inhibiting generation of the photoelectric conversion material. This action of the phosphate ester extends the pot life of the precursor solution and makes it possible to form a high-quality film, namely, a photoelectric conversion layer composed of a high-quality film. Hence, a photoelectric conversion element having an improved photoelectric conversion efficiency can be manufactured by the manufacturing method of the technique 10.

### (Technique 11)

The method according to the technique 10, wherein
the photoelectric conversion element is the photoelectric conversion element according to the technique 5,
the precursor solution contains, as the raw material of the photoelectric conversion material:
   a first compound including the A and a first halogen element as constituent elements; and
   a second compound including the B and a second halogen element as constituent elements, and
at least one selected from the group consisting of the first halogen element and the second halogen element includes I.

A photoelectric conversion element having an improved photoelectric conversion efficiency can be manufactured by the manufacturing method of the technique 11.

### (Technique 12)

The method according to the technique 11, wherein the A is an alkali metal element.

A photoelectric conversion element having an improved photoelectric conversion efficiency can be manufactured by the manufacturing method of the technique 12.

### (Technique 13)

The method according to the technique 12, wherein the first compound is cesium iodide.

A photoelectric conversion element having an improved photoelectric conversion efficiency can be manufactured by the manufacturing method of the technique 13.

### (Technique 14)

The method according to any one of the techniques 10 to 13, wherein the solvent further contains dimethylformamide.

The photoelectric conversion layer formed by the manufacturing method of the technique 14 can have a high film quality, and therefore a photoelectric conversion element having an improved photoelectric conversion efficiency can be manufactured by the manufacturing method of the technique 14.

### (Technique 15)

The method according to any one of the techniques 10 to 14, wherein
the precursor solution contains the phosphate ester so that an amount of the phosphate ester in the photoelectric conversion layer formed is more than 0 mol% and 9 mol% or less.

A photoelectric conversion element having an improved photoelectric conversion efficiency can be manufactured by the manufacturing method of the technique 15.

### (Technique 16)

A composition including:
at least one selected from the group consisting of a photoelectric conversion material and a precursor of the photoelectric conversion material;
a solvent containing dimethyl sulfoxide; and
a phosphate ester.

The composition of the technique 16 configured as above can be used, for example, as a precursor solution that can be used in manufacturing a photoelectric conversion element having an improved photoelectric conversion efficiency.

### (Technique 17)

The composition according to the technique 16, wherein
the photoelectric conversion material is a perovskite compound, and
the perovskite compound includes at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, Tl, Pb, Bi, Th, U, and Np.

The composition of the technique 17 configured as above can be used, for example, as a precursor solution that can be used in manufacturing a photoelectric conversion element having an improved photoelectric conversion efficiency.

### (Technique 18)

The composition according to the technique 17, wherein the perovskite compound includes Ge.

The composition of the technique 18 configured as above can be used, for example, as a precursor solution that can be used in manufacturing a photoelectric conversion element having an improved photoelectric conversion efficiency.

### (Technique 19)

The composition according to any one of the techniques 16 to 18, wherein
the photoelectric conversion material is represented by the following chemical formula (2):

AGeX₃ (2),

where
A is a monovalent cation, and
X is a halogen element and includes I.

The composition of the technique 19 configured as above can be used, for example, as a precursor solution that can be used in manufacturing a photoelectric conversion element having an improved photoelectric conversion efficiency.

### (Technique 20)

The composition according to the technique 19, wherein the A includes Cs.

The composition of the technique 20 configured as above can be used, for example, as a precursor solution that can be used in manufacturing a photoelectric conversion element having an improved photoelectric conversion efficiency.

### (Technique 21)

The composition according to any one of the techniques 16 to 20, wherein the solvent further contains dimethylformamide.

The composition of the technique 21 configured as above can be used, for example, as a precursor solution that can be used in manufacturing a photoelectric conversion element having an improved photoelectric conversion efficiency.

### (Technique 22)

The composition according to any one of the techniques 16 to 21, wherein the phosphate ester has a boiling point of 200°C or higher.

The composition of the technique 21 configured as above can be used, for example, as a precursor solution that can be used in manufacturing a photoelectric conversion element having an improved thermal resistance as well as an improved photoelectric conversion efficiency.

### (Technique 23)

The composition according to any one of the techniques 16 to 22, wherein the phosphate ester includes triphenyl phosphate.

The composition of the technique 23 configured as above can be used, for example, as a precursor solution that can be used in manufacturing a photoelectric conversion element having an improved photoelectric conversion efficiency.

### (Technique 24)

The composition according to any one of the techniques 16 to 23, wherein the precursor includes a compound composed of an alkali metal element and a halogen element.

The composition of the technique 24 configured as above can be used, for example, as a precursor solution that can be used in manufacturing a photoelectric conversion element having an improved photoelectric conversion efficiency.

### (Technique 25)

The composition according to the technique 24, wherein the compound is cesium iodide.

The composition of the technique 25 configured as above can be used, for example, as a precursor solution that can be used in manufacturing a photoelectric conversion element having an improved photoelectric conversion efficiency.

### EXAMPLES

The present disclosure will be described hereinafter in more details with reference to Examples and Comparative Example.

### <Production of photoelectric conversion element>

First, a glass substrate was prepared. The substrate plays the role of a supporting material for the photoelectric conversion element of the present disclosure.

An indium tin oxide (ITO) layer was formed on the substrate by sputtering. Furthermore, an antimony tin oxide (ATO) layer was formed on the ITO layer by sputtering. A first electrode was formed in this manner.

Next, a compact titanium oxide (TiO₂) layer was formed on the first electrode by sputtering. This compact titanium oxide (TiO₂) layer corresponds, for example, to the electron transport layer described in the above first embodiment.

Next, 0.3 g of a titanium oxide paste 30NR-D (manufactured by Gratcell Solar Materials Pty Ltd.) was dissolved in 2 mL of a butanol solution. The resulting solution was applied to the electron transport layer by spin coating, followed by baking at 500°C for 20 minutes. A porous titanium oxide layer was formed in this manner. The spin coating was performed at 4000 rpm for 20 seconds. It should be noted that both the above compact titanium oxide (TiO₂) layer and the above porous titanium oxide layer have an electron transport capability. Therefore, it can be considered that an electron transport layer is composed of the above compact titanium oxide (TiO₂) layer and the above porous titanium oxide layer.

A precursor solution of a photoelectric conversion layer was applied to the porous layer by spin coating, followed by baking at 120°C for 30 minutes. A photoelectric conversion layer was formed in this manner. The spin coating was performed at 2000 rpm for 45 seconds.

The precursor solution of the photoelectric conversion layer was obtained in the following manner. First, Gel₂ was dissolved in N,N-dimethylformamide (DMF) to obtain a 1.6 M Gel₂ solution. Then, triphenyl phosphate (TPPa) was dissolved in this solution. Next, Csl was dissolved in DMSO to obtain a 1.6 M Csl solution. Finally, the same volumes of the Gel₂ solution to which TPPa was added and the Csl solution were mixed to obtain 0.8 M CsGel₃. The precursor solution was used in the spin coating immediately after prepared.

In Examples, three types of precursor solutions were prepared. The TPPa concentrations in the Gel₂ solutions to which TPPa was added was 2 mol%, 6 mol%, and 18 mol%. In the precursor solutions, the TPPa concentrations were adjusted so that the amounts of TPPa in the photoelectric conversion layers formed would be 1 mol%, 3 mol%, and 9 mol%. ATPPa-free precursor solution was also prepared for Comparative Example.

Next, a raw material solution of a hole transport layer was applied to the photoelectric conversion layer by spin coating. A hole transport layer was formed in this manner. The raw material solution of the hole transport layer was prepared by dissolving 18 mg of poly(triaryl amine) (PTAA) in 1 mL of chlorobenzene. The spin coating was performed at 4000 rpm for 20 seconds.

The preparation of the raw material solutions of the photoelectric conversion layer and the hole transport layer, and the formation of the photoelectric conversion layer and the hole transport layer were carried out in a glove box in which the oxygen concentration and the moisture concentration were each 1 ppm or lower.

Subsequently, a 200 nm-thick gold film was formed by vacuum deposition.

Finally, a UV-curable epoxy resin was applied to a periphery of the substrate, another glass substrate was placed thereon, and the resulting laminate was irradiated with UV. The epoxy resin was thereby cured to encapsulate the electricity generation constituents.

Photoelectric conversion elements in which the amounts of TPPa in the photoelectric conversion layers were 1 mol%, 3 mol%, and 9 mol% were respectively photoelectric conversion elements of Examples 1, 2, and 3. ATPPa-free photoelectric conversion element, namely, a photoelectric conversion element in which the amount of TPPa in the photoelectric conversion layer is 0 mol% was a photoelectric conversion element of Comparative Example.

### <Evaluation of characteristics of photoelectric conversion element>

I-V characteristics were evaluated for the photoelectric conversion elements of Examples and Comparative Example.

A solar simulator (manufactured by Bunkoukeiki Co., Ltd.) and an electrochemical analyzer ALS (manufactured by BAS Inc.) were used for the evaluation of the characteristics. Each photoelectric conversion element was irradiated with one sun of simulated sunlight. The output of the solar simulator was set to 100 mW/cm². Current-voltage characteristics (namely, I-V characteristics) of the photoelectric conversion elements were measured by measuring output current values using the electrochemical analyzer under varying applied voltage.

Table 1 shows the measurement results. The symbol η represents the conversion efficiency. The symbol Jsc represents the short-circuit current density. The symbol V_{oc} represents the open-circuit voltage. The symbol FF represents the fill-factor.

FIG. 4 is a graph showing I-V characteristics under one-sun irradiation of the photoelectric conversion elements of Examples and Comparative Example. In FIG. 4, the horizontal axis represents the applied voltage, and the vertical axis represents the current density.

**[Table 1]**

| | TPPA (mol%) | η (%) | J_{sc} (mA/cm²) | V_{oc} (V) | FF |
|---|---|---|---|---|---|
| Comparative Example | 0 | 0.0008 | 0.048 | 0.057 | 0.278 |
| Example 1 | 1 | 0.0049 | 0.026 | 0.414 | 0.463 |
| Example 2 | 3 | 0.0026 | 0.024 | 0.277 | 0.383 |
| Example 3 | 9 | 0.0011 | 0.010 | 0.304 | 0.365 |

According to the result of the characteristic evaluation, the open-circuit voltage was significantly improved by adding TPPa, and thus the photoelectric conversion efficiency was improved.

As is obvious from Examples 1 and 2, a higher conversion efficiency can be achieved when the amount of TPPa is 1 mol% to 3 mol%.

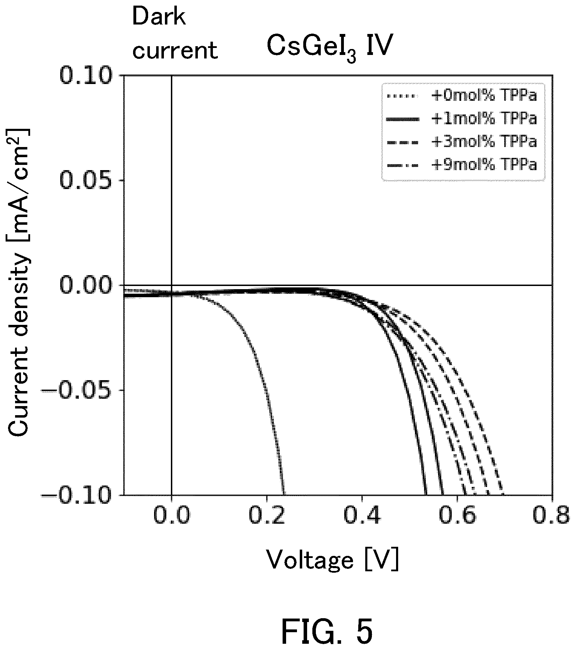

Regarding evaluation of characteristics of the photoelectric conversion elements, I-V characteristics without light irradiation, i.e., I-V characteristics under measurement of dark currents of the photoelectric conversion elements were also determined without irradiating the photoelectric conversion elements with simulated sunlight. FIG. 5 is a graph showing I-V characteristics under measurement of dark currents through the photoelectric conversion elements of Examples and Comparative Example. The upward shifts of the IV curves under one sun irradiation in FIG. 4 with respect to the I-V characteristics in FIG. 5 under measurement of the dark currents confirm photoelectric conversion by the photoelectric conversion elements.

In Examples 1 to 3 and Comparative Example shown above, evaluation of the photoelectric conversion elements was made for regular devices. In Example 4 below, evaluation of the photoelectric conversion elements was made for inverted devices.

A photoelectric conversion element of Example 4 was produced in the following manner.

First, a glass substrate was prepared. The substrate plays the role of a supporting material or the photoelectric conversion element of the present disclosure.

An ITO layer was formed on the substrate by sputtering. A first electrode was formed in this manner.

Next, an aqueous PEDOTPSS (poly(3,4-ethylenedioxythiophene) polystyrene sulfonate) dispersion was applied to the first electrode by spin coating, followed by baking at 180°C for 10 minutes. The spin coating was performed at 4000 rpm for 20 seconds. A hole transport layer was formed in this manner.

A precursor solution of a photoelectric conversion layer was applied to the hole transport layer by spin coating, followed by baking at 120°C for 30 minutes. A photoelectric conversion layer was formed in this manner. The spin coating was performed at 2000 rpm for 45 seconds.

The precursor solution of the photoelectric conversion layer was obtained in the following manner. First, Gel₂ was dissolved in N,N-dimethylformamide (DMF) to obtain a 1.6 M Gel₂ solution. Then, triphenyl phosphate (TPPa) was dissolved in this solution. Next, Csl was dissolved in DMSO to obtain a 1.6 M Csl solution. Finally, the same volumes of the Gel₂ solution to which TPPa was added and the Csl solution were mixed to obtain 0.8 M CsGel₃. The precursor solution was used in the spin coating immediately after prepared.

In Example 4, the TPPa concentration in the Gel₂ solution to which TPPa was added was 6 mol%. The TPPa concentration in the precursor solution was adjusted so that the amount of TPPa in the photoelectric conversion layer formed would be 3 mol%.

Next, an electron transport layer was formed on the photoelectric conversion layer by spin coating. The raw material solution of the electron transport layer was adjusted by dissolving 25 mg of [6,6]-phenyl C61 butyric acid methyl ester (PCBM) in 1 mL of chlorobenzene.

The preparation of the raw material solutions of the photoelectric conversion layer and the electron transport layer and the formation of the photoelectric conversion layer and the electron transport layer were carried out in a glove box in which the oxygen concentration and the moisture concentration were each 1 ppm or lower.

After that, by vacuum deposition, a bathocuproine (BCP) film was formed to a thickness of 6 nm and an Al film was formed to a thickness of 200 nm.

Finally, a UV-curable epoxy resin was applied to a periphery of the substrate, another glass substrate was placed thereon, and the resulting laminate was irradiated with UV. The epoxy resin was thereby cured to encapsulate the electricity generation constituents.

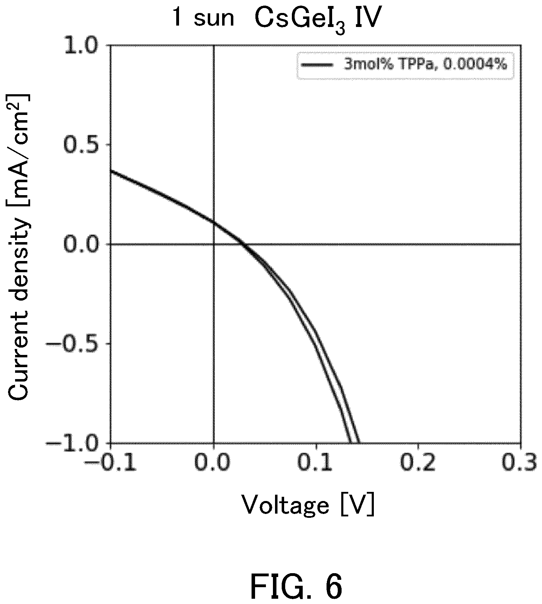

It has been confirmed that in the case that TPPa is added, an inverted CsGel₃ photoelectric conversion element formed by application can generate electricity. FIG. 6 shows I-V characteristics under one-sun irradiation of the inverted CsGel₃ device. It should be noted that the method for evaluating the I-V characteristics under one-sun irradiation of the inverted CsGel₃ device of Example 4 was the same as the method for evaluating those of the devices of Examples 1 to 3.

In the present Examples, examples where a phosphate ester was added to a photoelectric conversion layer including a Ge-containing perovskite compound as a photoelectric conversion material were used to confirm that the photoelectric conversion efficiency of an photoelectric conversion element is improved. The above effect can be achieved not only when a Ge-containing perovskite compound is used as a photoelectric conversion material, but also when, for example, a photoelectric conversion material includes an element that can cause a reaction, such as formation of a complex, with a solvent, such as DMSO, used in manufacturing. It is thought that, for example, when a perovskite compound including at least one element selected from the group consisting of Mg, Al, Si, Ca, Ti, V, Cr, Mn, Fe, Co, Ni, Cu, Zn, Ga, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, Tl, Pb, Bi, Th, U, and Np is used, the same action and effect as those achieved when a Ge-containing perovskite compound is used are achieved by addition of a phosphate ester.

### INDUSTRIAL APPLICABILITY

The photoelectric conversion element of the present disclosure can be included, for example, in solar cells.

## Claims

1. A photoelectric conversion element comprising:
a first electrode;
a photoelectric conversion layer; and
a second electrode, wherein
the photoelectric conversion layer comprises a photoelectric conversion material and a phosphate ester.

2. The photoelectric conversion element according to claim 1, wherein
the photoelectric conversion material is a perovskite compound, and
the perovskite compound comprises at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, Tl, Pb, Bi, Th, U, and Np.

3. The photoelectric conversion element according to claim 2, wherein the perovskite compound comprises Ge.

4. The photoelectric conversion element according to claim 2 or 3, wherein the phosphate ester is present between crystals of the perovskite compound.

5. The photoelectric conversion element according to any one of claims 1 to 4, wherein
the photoelectric conversion material is represented by the following chemical formula (1):
ABX₃ (1),
where
A is a monovalent cation,
B is at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, Tl, Pb, Bi, Th, U, and Np, and
X is a halogen element and includes I.

6. The photoelectric conversion element according to claim 5, wherein the A includes Cs.

7. The photoelectric conversion element according to any one of claims 1 to 6, wherein the phosphate ester has a boiling point of 200°C or higher.

8. The photoelectric conversion element according to any one of claims 1 to 7, wherein the phosphate ester comprises triphenyl phosphate.

9. The photoelectric conversion element according to any one of claims 1 to 8, wherein an amount of the phosphate ester in the photoelectric conversion layer is more than 0 mol% and 9 mol% or less.

10. A method for manufacturing the photoelectric conversion element according to any one of claims 1 to 9, the method comprising:
applying a precursor solution to a base to form a coating film, the precursor solution comprising a raw material of the photoelectric conversion material, the phosphate ester, and a solvent comprising dimethyl sulfoxide; and
baking the coating film to form the photoelectric conversion layer.

11. The method according to claim 10, wherein
the photoelectric conversion element is the photoelectric conversion element according to claim 5,
the precursor solution comprises, as the raw material of the photoelectric conversion material:
a first compound comprising the A and a first halogen element as constituent elements; and
a second compound comprising the B and a second halogen element as constituent elements, and
at least one selected from the group consisting of the first halogen element and the second halogen element comprises I.

12. The method according to claim 11, wherein the A is an alkali metal element.

13. The method according to claim 12, wherein the first compound is cesium iodide.

14. The method according to any one of claims 10 to 13, wherein the solvent further comprises dimethylformamide.

15. The method according to any one of claims 10 to 14, wherein
the precursor solution comprises the phosphate ester so that an amount of the phosphate ester in the photoelectric conversion layer formed is more than 0 mol% and 9 mol% or less.

16. A composition comprising:
at least one selected from the group consisting of a photoelectric conversion material and a precursor of the photoelectric conversion material;
a solvent comprising dimethyl sulfoxide; and
a phosphate ester.

17. The composition according to claim 16, wherein
the photoelectric conversion material is a perovskite compound, and
the perovskite compound comprises at least one selected from the group consisting of Mg, Al, Si, Ca, Ti, V, Cr, Mn, Fe, Co, Ni, Cu, Zn, Ga, Ge, As, Sr, Y, Zr, Nb, Mo, Tc, Ru, Rh, Pd, Ag, Cd, In, Sn, Sb, Ba, La, Ce, Pr, Nd, Sm, Eu, Gd, Tb, Dy, Er, Yb, Lu, Ta, W, Re, Os, Ir, Pt, Au, Hg, TI, Pb, Bi, Th, U, and Np.

18. The composition according to claim 17, wherein the perovskite compound comprises Ge.

19. The composition according to any one of claims 16 to 18, wherein
the photoelectric conversion material is represented by the following chemical formula (2):
AGeX₃ (2),
where
A is a monovalent cation, and
X is a halogen element and comprises I.

20. The composition according to claim 19, wherein the A comprises Cs.

21. The composition according to any one of claims 16 to 20, wherein the solvent further comprises dimethylformamide.

22. The composition according to any one of claims 16 to 21, wherein the phosphate ester has a boiling point of 200°C or higher.

23. The composition according to any one of claims 16 to 22, wherein the phosphate ester comprises triphenyl phosphate.

24. The composition according to any one of claims 16 to 23, wherein the precursor comprises a compound composed of an alkali metal element and a halogen element.

25. The composition according to claim 24, wherein the compound is cesium iodide.
